# EUROPEAN PATENT APPLICATION

(11) **EP 4 036 802 A1**
(43) Date of publication of application: **03.08.2022**
(21) Application number: 19946635.0
(22) Date of filing: 27.09.2019
(51) Int. Cl.: G06N 3/02

(54) **DATA PROCESSING DEVICE, DATA PROCESSING SYSTEM, AND DATA PROCESSING METHOD**

(71) Applicant: MITSUBISHI ELECTRIC CORPORATION, Chiyoda-ku Tokyo 100-8310 (JP)
(72) Inventor: MINEZAWA, Akira, Chiyoda-ku, Tokyo 100-8310 (JP)
(74) Representative: Pfenning, Meinig & Partner mbB
(86) International application number: PCT/JP2019/038133
(87) International publication number: WO 2021/059476

(57) **Abstract**

There are included a data processing unit (10) that trains a neural network; and an encoding unit (11) that generates encoded data in which model header information for identifying a model of the neural network, layer header information for identifying one or more layers of the neural network, and layer-by-layer edge weight information are encoded, and the encoding unit (11) encodes layer structure information indicating a layer structure of the neural network, and a new layer flag indicating whether each of the layers to be encoded is a layer to be updated from a corresponding layer of a reference model, or a new layer.

## Description

### TECHNICAL FIELD

The present invention relates to a data processing device, a data processing system, and a data processing method that generate encoded data in which information about a configuration of a neural network is encoded.

### BACKGROUND ART

As for a method for solving classification (discrimination) problems and regression problems of input data, there is machine learning. For the machine learning, there is a technique called a neural network that imitates a brain's neural circuit (neurons). In the neural network (hereinafter, referred to as NN), classification (discrimination) or regression of input data is performed using a probabilistic model (a discriminative model or a generative model) represented by a network in which neurons are mutually connected.

In addition, the NN can achieve high performance by optimizing parameters of the NN by training using a large amount of data. Note, however, that NNs in recent years have increased in size and there is a tendency toward an increase in the data size of NNs, and the computational load on a computer using an NN has also increased.

For example, Non-Patent Literature 1 describes a technique for scalar-quantizing edge weights (including bias values) which are pieces of information indicating a configuration of an NN and then encoding the edge weights. By scalar-quantizing edge weights and then encoding the edge weights, the data size of data about edges is compressed.

### CITATION LIST

### NON-PATENT LITERATURE

Non-Patent Literature 1: Vincent Vanhoucke, Andrew Senior, Mark Z. Mao, "Improving the speed of neural networks on CPUs", Proc. Deep Learning and Unsupervised Feature Learning NIPS Workshop, 2011.

### SUMMARY OF INVENTION

### TECHNICAL PROBLEM

There is a system having a plurality of clients connected to a server through a data transmission network, in which data representing a structure of an NN trained on a server side is encoded and the encoded data is decoded on a client side, by which each of the plurality of clients performs data processing using the NN trained by the server. In a conventional system, when a structure of an NN is updated, in addition to information about an updated layer, information about a layer that has not been updated is also transmitted to clients. Hence, there is a problem that a size of data to be transmitted cannot be reduced.

The present invention is to solve the above-described problem, and an object of the present invention is to obtain a data processing device, a data processing system, and a data processing method that can reduce a data size of data representing a structure of an NN

### SOLUTION TO PROBLEM

A data processing device according to the present invention includes a data processing unit for training an NN; and an encoding unit for generating encoded data in which model header information for identifying a model of the NN, layer header information for identifying one or more layers of the NN, and layer-by-layer edge weight information are encoded, and the encoding unit encodes layer structure information indicating a layer structure of the neural network, and a new layer flag indicating whether each of the layers to be encoded is a layer to be updated from a corresponding layer of a reference model, or a new layer.

### ADVANTAGEOUS EFFECTS OF INVENTION

According to the present invention, the encoding unit encodes layer structure information indicating a layer structure of an NN, and a new layer flag indicating whether each layer to be encoded is a layer to be updated from a corresponding layer of a reference model, or a new layer. Of pieces of data representing a structure of the NN, only information about an updated layer is encoded and transmitted, and thus, a data size of the pieces of data representing the structure of the NN can be reduced.

### BRIEF DESCRIPTION OF DRAWINGS

FIG. 1 is a block diagram showing a configuration of a data processing system according to a first embodiment.
FIG. 2 is a diagram showing an exemplary configuration of an NN
FIG. 3 is a block diagram showing a configuration of a data processing device (encoder) according to the first embodiment.
FIG. 4 is a block diagram showing a configuration of a data processing device (decoder) according to the first embodiment.
FIG. 5 is a flowchart showing operation of the data processing device (encoder) according to the first embodiment.
FIG. 6 is a flowchart showing operation of the data processing device (decoder) according to the first embodiment.
FIG. 7 is a diagram showing an example of encoded data in the first embodiment.
FIG. 8 is a diagram showing another example of encoded data in the first embodiment.
FIG. 9 is a diagram showing an example of a convolution process for one-dimensional data in the first embodiment.
FIG. 10 is a diagram showing an example of a convolution process for two-dimensional data in the first embodiment.
FIG. 11 is a diagram showing a matrix of node-by-node edge weight information in an lth layer of an NN
FIG. 12 is a diagram showing a matrix of quantization steps for the node-by-node edge weight information in the lth layer of the NN
FIG. 13 is a diagram showing a matrix of edge weight information in a convolutional layer.
FIG. 14 is a diagram showing a matrix of quantization steps for the edge weight information in the convolutional layer.
FIG. 15 is a block diagram showing a configuration of a variant of the data processing device (encoder) according to the first embodiment.
FIG. 16 is a diagram showing an overview of an update to encoded data in the first embodiment.
FIG. 17 is a diagram showing configurations of network models corresponding to the update to the encoded data shown in FIG. 16.
FIG. 18 is a diagram showing examples of layer structure information included in a model information header.
FIG. 19 is a diagram showing examples of layer identification information corresponding to the layer structure information included in the model information header.
FIG. 20A is a block diagram showing a hardware configuration that implements functions of the data processing device according to the first embodiment, and FIG. 20B is a block diagram showing a hardware configuration that executes software that implements the functions of the data processing device according to the first embodiment.

### DESCRIPTION OF EMBODIMENTS

### First Embodiment.

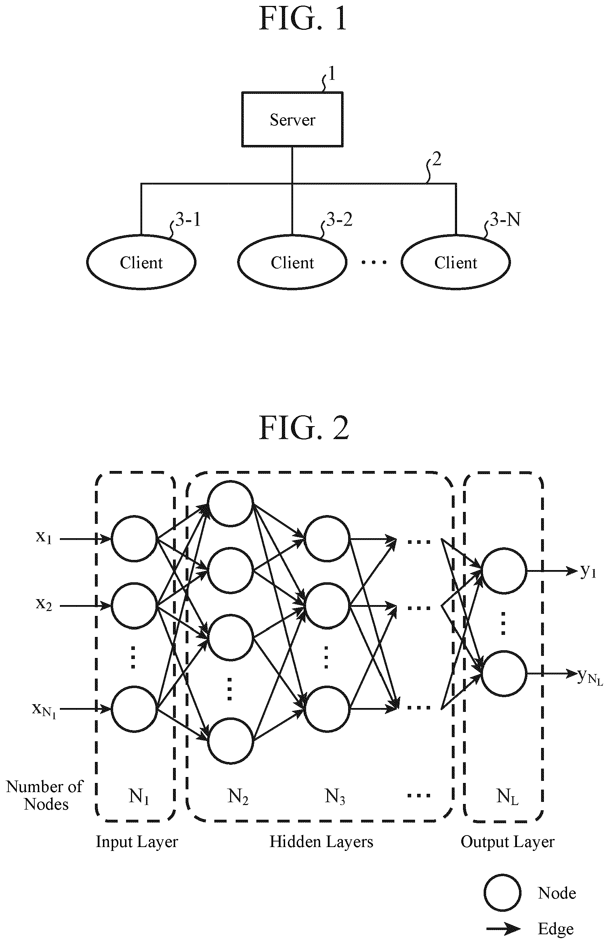

FIG. 1 is a block diagram showing a configuration of a data processing system according to a first embodiment. In the data processing system shown in FIG. 1, a server 1 is connected to clients 3-1, 3-2, ..., 3-N through a data transmission network 2. N is a natural number greater than or equal to 2. The server 1 is a data processing device that optimizes parameters of an NN (neural network) by training using a large amount of data, thereby creating a high-performance NN, and is a first data processing device included in the data processing system shown in FIG. 1.

The data transmission network 2 is a network through which data exchanged between the server 1 and the clients 3-1, 3-2, ..., 3-N is transmitted, and is the Internet or an intranet. For example, in the data transmission network 2, information for creating an NN is transmitted from the server 1 to the clients 3-1, 3-2, ..., 3-N.

The clients 3-1, 3-2, ..., 3-N are devices that each create an NN trained by the server 1 and perform data processing using the created NN For example, the clients 3-1, 3-2, ..., 3-N are devices having a communication function and a data processing function such as personal computers (PCs), cameras, or robots. Each of the clients 3-1, 3-2, ..., 3-N is a second data processing device included in the data processing system shown in FIG. 1.

In the data processing system shown in FIG. 1, the data size of a model and parameters of an NN and a value indicating appropriate performance vary between the clients 3-1, 3-2, ..., 3-N. Hence, even if the model and parameters of an NN are encoded using the technique described in Non-Patent Literature 1, the encoded data needs to be compressed to a data size suitable for each of the clients 3-1, 3-2, ..., 3-N, and thus, the processing load for encoding increases.

Hence, in the data processing system according to the first embodiment, the server 1 generates encoded data in which model header information for identifying a model of an NN, layer header information for identifying a layer of the NN, and information on layer-by-layer edge weights including bias values (hereinafter, an edge weight includes a bias value unless otherwise specified) are encoded, and transmits the encoded data to each of the clients 3-1, 3-2, ..., 3-N through the data transmission network 2. Each of the clients 3-1, 3-2, ..., 3-N can decode only information about a required layer, out of the encoded data transmitted from the server 1 through the data transmission network 2. Thus, the processing load for encoding on the server 1 decreases, and a reduction in a size of data transmitted to the data transmission network 2 from the server 1 can be achieved.

Now, a configuration of an NN will be described. FIG. 2 is a diagram showing an exemplary configuration of an NN As shown in FIG. 2, input data (x₁, x₂, ..., x_{N1}) is processed by each layer included in the NN, and processing results (yi, ..., y_{NL}) are outputted. Nₗ (l = 1, 2, ..., L) indicates the number of nodes in an lth layer, and L indicates the number of layers in the NN As shown in FIG. 2, the NN includes an input layer, hidden layers, and an output layer, and it is structured that a plurality of nodes are connected to each of these layers by edges. An output value of each of a plurality of nodes can be calculated from output values of nodes in a previous layer that are connected to each of the plurality of nodes by edges, edge weights, and an activation function set for each layer.

NNs include, for example, a convolutional neural network (CNN) including not only fully-connected layers but also convolutional layers and pooling layers. The CNN can create a network that implements data processing other than classification and regression, such as a network that implements a data filtering process.

For example, with an image or audio being input, the CNN can implement an image or audio filtering process that achieves noise removal or an improvement in the quality of an input signal, a high-frequency restoration process for audio with missing high frequencies of compressed audio, inpainting for an image whose partial image region is missing, or a super-resolution process for an image. The CNN can also construct an NN that includes a combination of a generative model and a discriminative model and that determines whether data is real by using the discriminative model, the discriminative model determining whether or not data is generated by the generative model.

In recent years, there has also been proposed a new NN called a generative adversarial network that is adversarially trained in such a manner that a discriminative model can distinguish data generated by a generative model from real data, so that the generative model does not generate data that can be distinguished, by the discriminative model, from real data. This NN can create a high-accuracy generative model and discriminative model.

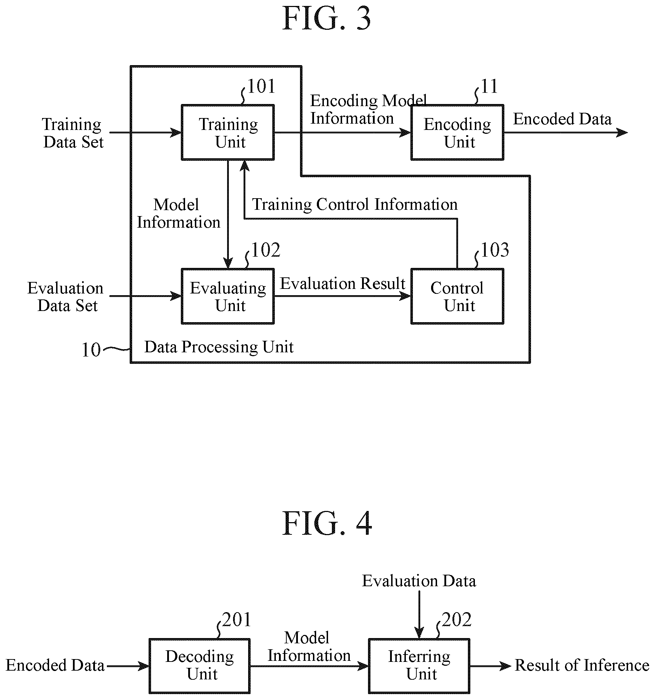

FIG. 3 is a block diagram showing a configuration of a data processing device (encoder) according to the first embodiment. The data processing device shown in FIG. 3 is a first data processing device that trains an NN using a training data set and an evaluation data set, and generates encoded data of model information indicating a configuration of the NN (hereinafter, referred to as model information), and is, for example, the server 1 shown in FIG. 1.

The data processing device shown in FIG. 3 includes a data processing unit 10 and an encoding unit 11. The data processing unit 10 is a first data processing unit that trains an NN, and includes a training unit 101, an evaluating unit 102, and a control unit 103. The encoding unit 11 generates encoded data in which model header information that identifies a model of an NN trained by the training unit 101, layer header information that identifies a layer of the NN, and layer-by-layer edge weight information are encoded. In addition, the encoding unit 11 encodes layer structure information of a layer to be encoded (encoded layer) and encodes a new layer flag. The layer structure information is information indicating a layer structure of an NN The new layer flag is flag information for identifying whether the corresponding layer is a layer to be newly added or a layer obtained by updating an already existing layer, and details of the new layer flag will be described later.

The training unit 101 performs a training process for an NN using a training data set, thereby generating model information of the trained NN The model information is outputted to the evaluating unit 102 from the training unit 101. Furthermore, the training unit 101 has encoding model information that is controlled by the control unit 103 which will be described later, and outputs the encoding model information to the encoding unit 11 when the training unit 101 receives a training completion instruction from the control unit 103. The evaluating unit 102 creates an NN using the model information, and performs an inference process from an evaluation data set, using the created NN The value of an evaluation index obtained as a result of the inference process is an evaluation result, and the evaluation result is outputted to the control unit 103 from the evaluating unit 102. The evaluation index is set in the evaluating unit 102 and is, for example, inference accuracy or an output value of a loss function.

The control unit 103 determines whether or not to update the model of the NN trained by the training unit 101 and whether or not the training unit 101 can complete the training of the NN, from an evaluation value obtained as the evaluation result by the evaluating unit 102, and controls the training unit 101 on the basis of results of the determination. For example, the control unit 103 compares the evaluation value with a model update criterion, and determines whether or not to update the model information as encoding model information, on the basis of a result of the comparison. In addition, the control unit 103 compares the evaluation value with a training completion criterion and, determines whether or not to complete the training of the NN by the training unit 101, on the basis of a result of the comparison. Note that these criteria are determined from a history of evaluation values.

FIG. 4 is a block diagram showing a configuration of a data processing device (decoder) according to the first embodiment. The data processing device shown in FIG. 4 is a second data processing device that creates an NN by decoding encoded data generated by the encoding unit 11 shown in FIG. 3, and performs an inference process on one or more pieces of evaluation data using the created NN, and corresponds to, for example, the clients 3-1, 3-2, ..., 3-N shown in FIG. 1.

The data processing device shown in FIG. 4 includes a decoding unit 201 and an inferring unit 202. The decoding unit 201 decodes model information from encoded data generated by the encoding unit 11. For example, the decoding unit 201 can decode only information required for the data processing device shown in FIG. 4, from the encoded data.

The inferring unit 202 is a second data processing unit that creates an NN using the model information decoded by the decoding unit 201, and performs data processing that uses the created NN For example, the data processing is an inference process for evaluation data using the NN The inferring unit 202 performs an inference process for evaluation data using the NN and outputs a result of the inference.

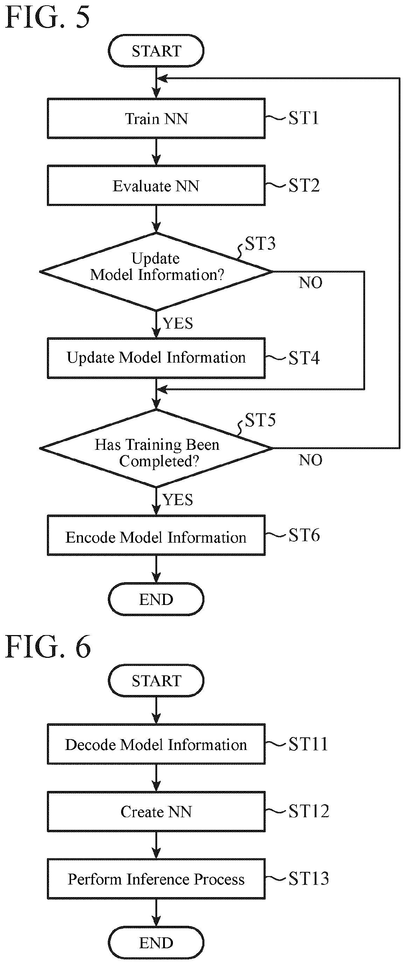

Next, operation of the data processing system according to the first embodiment will be described. FIG. 5 is a flowchart showing operation of the data processing device (encoder) according to the first embodiment and shows a data processing method performed by the data processing device shown in FIG. 3. The training unit 101 trains an NN (step ST1). For example, the training unit 101 trains an NN using a training data set, and outputs model information obtained by the training to the evaluating unit 102.

The model information is information indicating a configuration of a model of the NN, and is configured to include layer structure information indicating a structure for each layer and weight information of each edge belonging to the layer. The layer structure information includes layer type information, configuration information about a layer type, and information other than edge weights that is required to form a layer. The information other than edge weights that is required to form a layer includes, for example, an activation function. The layer type information is information indicating a layer type, and by referring to the layer type information, a layer type such as a convolutional layer, a pooling layer, or a fully-connected layer can be identified.

The configuration information about a layer type is information indicating a configuration of a layer of a type corresponding to the layer type information. For example, when the layer type corresponding to the layer type information indicates a convolutional layer, the configuration information about a layer type includes pieces of information indicating the number of channels that perform convolution, the data size and shape of a convolutional filter (kernel), a convolution interval (stride), whether or not there is padding on boundaries of input signals for a convolution process, and a method for padding when there is padding. In addition, when the layer type corresponding to the layer type information indicates a pooling layer, the configuration information about a layer type includes pieces of information indicating a pooling method such as max pooling or average pooling, the shape of a kernel that performs a pooling process, a pooling interval (stride), whether or not there is padding on boundaries of input signals for a pooling process, and a method for padding when there is padding.

For information indicating each edge weight, weights may be independently set for respective edges as in a fully-connected layer. On the other hand, as in a convolutional layer, an edge weight may be common per convolutional filter (kernel) (per channel), i.e., an edge weight may be common in one filter.

The evaluating unit 102 evaluates the NN (step ST2). For example, the evaluating unit 102 creates an NN using the model information generated by the training unit 101, and performs an inference process from an evaluation data set, using the created NN An evaluation result is outputted to the control unit 103 from the evaluating unit 102. The evaluation result is, for example, inference accuracy or an output value of a loss function.

Then, the control unit 103 determines whether or not to update the model information (step ST3). For example, when an evaluation value generated by the evaluating unit 102 does not satisfy a model update criterion, the control unit 103 determines not to update encoding model information held in the training unit 101, and when the evaluation value satisfies the model update criterion, the control unit 103 determines to update the encoding model information.

As for an example of the model update criterion, when the evaluation value is an output value of a loss function, an evaluation value obtained by training this time can be smaller than a minimum evaluation value in a training history recorded from the start of training. As for another example, when the evaluation value is inference accuracy, an evaluation value obtained by training this time can be larger than a maximum evaluation value in a training history recorded from the start of training.

In addition, a switching unit of a training history may be any unit. For example, it is assumed that a training history is provided for each model identification number (model_id) which will be described later. In this case, when the model does not have a reference model identification number (reference_model_id) which will be described later, it is considered that there is no training history, and training starts. Namely, at step ST3 performed for the first time, model information is always updated. On the other hand, when the model has a reference model identification number, a training history (history A) of a model indicated by the reference model identification number is referred to. As a result, upon training the model, the model can be prevented from being updated to a model whose evaluation value is poorer (lower inference accuracy, a larger value of the loss function, etc.) than that of the model indicated by the reference model identification number. In this case, when the model identification number of the model is identical to the reference model identification number, every time the model is trained, the training history (history A) corresponding to the reference model identification number is updated. On the other hand, when the model identification number of the model differs from the reference model identification number, the training history (history A) corresponding to the reference model identification number is copied as an initial value of a training history (history B) of the model identification number of the model, and then every time the model is trained, the training history (history B) of the model is updated.

If the control unit 103 determines to update the model information (step ST3; YES), then the training unit 101 updates the encoding model information to the model information (step ST4). For example, the control unit 103 generates model update instruction information indicating that there is an update to the model information, and outputs training control information including the model update instruction information to the training unit 101. The training unit 101 updates the encoding model information to the model information in accordance with the model update instruction information included in the training control information.

On the other hand, if it is determined not to update the model information (step ST3; NO), then the control unit 103 generates model update instruction information indicating that there is no update to the model information, and outputs training control information including the model update instruction information to the training unit 101. The training unit 101 does not update the encoding model information in accordance with the model update instruction information included in the training control information.

Then, the control unit 103 compares the evaluation value with a training completion criterion, and determines whether or not to complete the training of the NN by the training unit 101, on the basis of a result of the comparison (step ST5). For example, as for the training completion criterion, when it is determined whether or not the evaluation value generated by the evaluating unit 102 has reached a specific value, if the evaluation value generated by the evaluating unit 102 has satisfied the training completion criterion, then the control unit 103 determines that the training of the NN by the training unit 101 has been completed, and if the evaluation value has not satisfied the training completion criterion, then the control unit 103 determines that the training of the NN by the training unit 101 has not been completed. Alternatively, for example, when the training completion criterion is based on the latest training history, e.g., it is determined that the training has been completed when no update to the model information (step ST3; NO) is selected M times in a row (M is a predetermined integer greater than or equal to 1), if the training history has not satisfied the training completion criterion, then the control unit 103 determines that the training of the NN by the training unit 101 has not been completed.

If the control unit 103 determines that the training of the NN has been completed (step ST5; YES), then the training unit 101 outputs the encoding model information to the encoding unit 11, and the processing transitions to a process at step ST6. On the other hand, if the control unit 103 determines that the training of the NN has not been completed (step ST5; NO), then the processing is performed from step ST1.

The encoding unit 11 encodes the encoding model information inputted from the training unit 101 (step ST6). The encoding unit 11 encodes the encoding model information generated by the training unit 101, on a per NN layer basis, thereby generating encoded data including header information and layer-by-layer encoded data. In addition, the encoding unit 11 encodes layer structure information, and encodes a new layer flag.

FIG. 6 is a flowchart showing operations of the data processing device (decoder) according to the first embodiment and shows operations of the data processing device shown in FIG. 4. The decoding unit 201 decodes model information from encoded data obtained by encoding in the encoding unit 11 (step ST11). Then, the inferring unit 202 creates an NN from the model information decoded by the decoding unit 201 (step ST12). The inferring unit 202 performs an inference process on evaluation data using the created NN, and outputs a result of the inference (step ST13).

Next, encoding of model information by the encoding unit 11 at step ST6 of FIG. 5 will be described in detail. For the encoding of model information by the encoding unit 11, for example, an encoding method (1) or (2) can be used. Alternatively, which one of encoding (1) and (2) is used may be defined for each parameter. For example, by using (1) for header information and (2) for weight data, while the decoder can easily analyze the header information without performing variable length decoding thereon, the decoder can implement high compression by variable length decoding for the weight data that occupies a large part of the data size of encoded data, by which the data size of the entire encoded data can be suppressed.
(1) Data in which bit strings themselves including header information if the header information is present are arranged in a preset order is encoded data. In each of the bit strings, a parameter included in each piece of information included in model information is described at bit precision defined in the parameter. The bit precision is bit precision defined in a parameter, e.g., 8-bit int or 32-bit float.
(2) Data in which bit strings themselves including header information are arranged in a preset order is encoded data. In each of the bit strings, a parameter included in each piece of information included in model information is encoded by a variable length coding method set for each parameter.

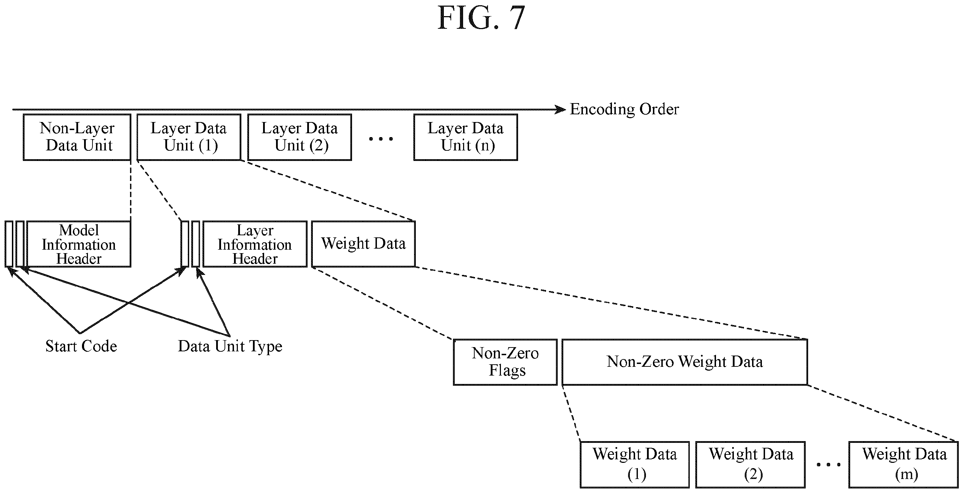

FIG. 7 is a diagram showing an example of encoded data in the first embodiment, and the encoded data in the above-described (1) or (2) may be disposed in order shown in FIG. 7. The encoded data shown in FIG. 7 includes a collection of pieces of data called data units, and the data units include a non-layer data unit and a layer data unit. The layer data unit is a data unit that stores layer data which is layer-by-layer encoded data.

The layer data includes a start code, a data unit type, a layer information header, and weight data. The layer information header is obtained by encoding layer header information for identifying a layer of an NN The weight data is obtained by encoding weight information of edges belonging to a layer indicated by the layer information header. Note that in the encoded data shown in FIG. 7, the order of arrangement of the layer data units is not necessarily the same as the order of arrangement of layers of the NN and is any order. The reason therefor is that a layer identification number (layer id) which will be described later can identify which position's layer of the NN each of the layer data units corresponds to.

The non-layer data unit is a data unit that stores data other than layer data. For example, the non-layer data unit stores a start code, a data unit type, and a model information header. The model information header is obtained by encoding model header information for identifying a model of an NN

The start code is a code stored in a start position of the data unit to identify the start position of the data unit. The clients 3-1, 3-2, ..., 3-N (hereinafter, referred to as decoding side) can identify a start position of a non-layer data unit or a layer data unit by referring to a start code. For example, when 0x000001 is defined as a start code, data stored in the data unit other than the start code is set in such a manner that 0x000001 does not occur. As a result, the start position of the data unit can be identified from the start code.

In order to set in such a manner that 0x000001 does not occur, for example, 03 is inserted into the third byte of encoded data "0x000000 to 0x000003", thereby resulting in 0x000300 to 0x000303, and upon decoding, 0x0003 is converted into 0x0000, by which the data can be brought back to the original one. Note that as long as the start code is a bit string that can be uniquely identified, a bit string other than 0x000001 may be defined as the start code. In addition, as long as a method can identify a start position of a data unit, a start code does not need to be used. For example, a bit string that can identify an end of a data unit may be added to the end of the data unit. Alternatively, a start code may be added only to the start of a non-layer data unit, and as a part of a model information header, the data size of each layer data unit may be encoded. Therefore, a separation position between any two adjacent layer data units can be identified from the above-described information.

The data unit type is data stored after the start code in the data unit to identify the type of the data unit. For the data unit type, a value is defined for each type of data unit in advance. By referring to the data unit type stored in the data unit, the decoding side can identify whether the data unit is a non-layer data unit or a layer data unit, and can further identify what kind of non-layer data unit or layer data unit the data unit is.

The model information header in the non-layer data unit includes a model identification number (model_id), the number of layer data units in a model (num layers), and the number of encoded layer data units (num_coded_layers). The model identification number is a number for identifying a model of an NN Thus, basically, individual models have numbers independent of each other, but if a data processing device (decoder) according to the first embodiment has newly received a model having the same model identification number as that of a model received in the past, then the past received model having the model identification number is overwritten. The number of layer data units in a model is the number of layer data units included in the model identified by the model identification number. The number of encoded layer data units is the number of layer data units actually present in encoded data. In the example of FIG. 7, there are layer data units (1) to (n), and thus, the number of encoded layer data units is n. Note that the number of encoded layer data units is always less than or equal to the number of layer data units in the model.

A layer information header in a layer data unit includes a layer identification number (layer id) and layer structure information. The layer identification number is a number for identifying a layer. In order to be able to identify the corresponding layer by the layer identification number, how to assign the values of layer identification numbers is fixedly defined in advance. For example, the numbers are assigned in order from a layer close to an input layer to a subsequent layer, e.g., the input layer of an NN is assigned 0 and a subsequent layer is assigned 1. The layer structure information is information indicating a configuration for each layer of the NN and includes layer type information, configuration information about a layer type, and information other than edge weights that is required to form a layer. The layer structure information includes, for example, information of only the corresponding layer portion in model_structure_information and layer_id_information which will be described later. Furthermore, the layer structure information includes weight bit length indicating the bit precision of each edge weight of the corresponding layer. For example, when weight bit length = 8, it indicates that the weight is 8-bit data. Thus, the bit precision of an edge weight can be set on a layer-by-layer basis. As a result, it is possible to perform adaptive control, e.g., bit precision is changed on a layer-by-layer basis, depending on the importance of a layer (the degree of influence exerted by bit precision on an output result).

Note that although a layer information header including layer structure information has been shown so far, a model information header may include all pieces of layer structure information (model_structure_information) included in encoded data and layer identification information (layer_id_information) corresponding to the pieces of layer structure information. The decoding side can identify the configurations of layers with respective layer identification numbers by referring to the model information header. Furthermore, in the above-described case, since the configurations of layers with respective layer identification numbers can be identified by referring to the model information header, a layer information header may include only a layer identification number. Therefore, when the data size of a layer data unit is greater than the data size of a non-layer data unit, the data size of each layer data unit can be reduced, thereby enabling a reduction in the maximum data size of data units in encoded data.

In the layer data unit, weight data which is encoded on a layer-by-layer basis is stored after the layer information header. The weight data includes non-zero flags and non-zero weight data. The non-zero flag is a flag indicating whether or not an edge weight value is zero, and is set for each of all the edge weights belonging to a corresponding layer.

The non-zero weight data is data that is set after the non-zero flags in the weight data. In the non-zero weight data, the value of a weight whose non-zero flag indicates non-zero (significant) is set. In FIG. 7, weight data (1) to weight data (m) each indicating a non-zero weight value are set as non-zero weight data. The number m of pieces of non-zero weight data is less than or equal to the number Mi of all weights in a corresponding layer 1. Note that weight data about a layer having sparse edges with a non-zero weight value has a very small amount of non-zero weight data and includes substantially only non-zero flags, and thus, the data size of the weight data is significantly reduced.

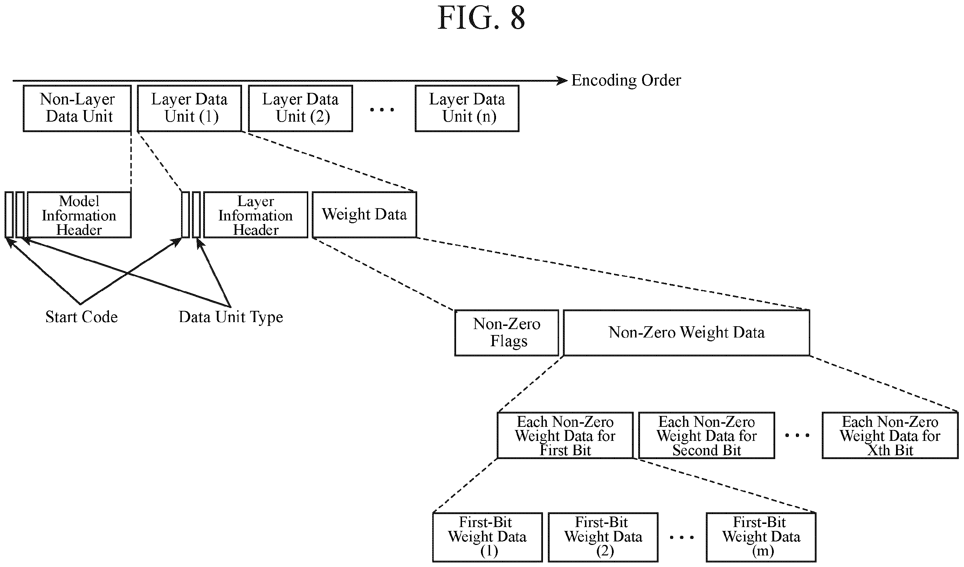

FIG. 8 is a diagram showing another example of encoded data in the first embodiment, and the encoded data in the above-described (1) or (2) may be disposed in order shown in FIG. 8. The encoded data shown in FIG. 8 differs from that of FIG. 7 in the data configuration of weight data, and in non-zero weight data, the weights of all edges belonging to a corresponding layer are collectively arranged bit-plane by bit-plane in order from higher bits. Furthermore, in a layer information header, bit-plane data position identification information indicating a start position of each bit indicating an edge weight is set.

For example, when bit precision defined for edge weights is X, the weights of all edges belonging to a corresponding layer each are described at bit precision X. Out of a bit string of these weights, the encoding unit 11 sets, as each non-zero weight data for the first bit, first-bit weight data (1), first-bit weight data (2), ..., first-bit weight data (m) which are first-bit non-zero weight data. This process is repeated for second-bit non-zero weight data to Xth-bit non-zero weight data. Note that the first-bit weight data (1), the first-bit weight data (2), ..., the first-bit weight data (m) are pieces of non-zero weight data that form a first-bit bit-plane.

The decoding side identifies required encoded data among pieces of layer-by-layer encoded data on the basis of bit-plane data position identification information, and can decode the identified encoded data at any bit precision. Namely, the decoding side can select only required encoded data from encoded data and decode model information of an NN suited for an environment on the decoding side. Note that the bit-plane data position identification information may be any information as long as a separation position between any two adjacent pieces of bit-plane data can be identified, and may be information indicating a start position of each piece of bit-plane data or may be information indicating the data size of each piece of bit-plane data.

When the transmission band of the data transmission network 2 is not sufficient to transmit all pieces of encoded data representing a configuration of an NN to the decoding side, the encoding unit 11 may limit non-zero weight data to be transmitted out of the pieces of encoded data, on the basis of the transmission band of the data transmission network 2. For example, in a bit string of weight information described at 32-bit precision, the higher 8 bits of non-zero weight data is set as a transmission target. The decoding side can recognize, from a start code disposed after the non-zero weight data, that a layer data unit corresponding to a next layer is arranged after 8th-bit non-zero weight data in encoded data. In addition, the decoding side can properly decode a weight whose value is zero by referring to a non-zero flag in weight data.

In order to improve, when weight data is decoded at any bit precision by the decoding side, inference accuracy at the bit precision, the encoding unit 11 may include, in a layer information header, an offset to be added to a weight decoded at each bit precision. For example, the encoding unit 11 adds an offset which is uniform per layer to a bit string of weights described at bit precision, determines an offset with the highest precision, and includes the determined offset in a layer information header and performs encoding.

In addition, the encoding unit 11 may include, in a model information header, offsets for edge weights in all layers included in an NN, and perform encoding. Furthermore, the encoding unit 11 may set a flag indicating whether or not an offset is included, in a layer information header or a model information header, and for example, only when the flag indicates availability of an offset, the offset may be included in encoded data.

The encoding unit 11 may set a difference between an edge weight value and a specific value, as an encoding target.

The specific value includes, for example, an immediately previous weight in encoding order. In addition, a corresponding edge weight belonging to a layer higher by one level (a layer close to an input layer) may be used as the specific value, or a corresponding edge weight in a model before update may be used as the specific value.

Furthermore, the encoding unit 11 has functions shown in (A), (B), and (C).
(A) The encoding unit 11 has a scalable encoding function that performs encoding for base encoded data and enhancement encoded data separately.
(B) The encoding unit 11 has a function of encoding a difference from an edge weight in a reference NN
(C) The encoding unit 11 has a function of encoding, as NN update information, only partial information (e.g., layer-by-layer information) of the reference NN

An example of (A) will be described.

The encoding unit 11 quantizes an edge weight using a quantization method which is defined in advance for the edge weight, sets data obtained by encoding the quantized weight, as base encoded data, and sets data obtained by encoding a quantization error that is considered a weight, as enhancement encoded data. The weight as the base encoded data is lower in bit precision than the weight before quantization due to the quantization, and thus, the data size is reduced. When a transmission band used to transmit encoded data to the decoding side is not sufficient, the data processing device according to the first embodiment transmits only the base encoded data to the decoding side. On the other hand, when a transmission band used to transmit encoded data to the decoding side is sufficient, the data processing device according to the first embodiment transmits not only the base encoded data but also the enhancement encoded data to the decoding side.

Two or more pieces of enhancement encoded data can be used. For example, the encoding unit 11 sets a quantized value obtained when a quantization error is further quantized, as first enhancement encoded data, and sets a quantization error thereof, as second enhancement encoded data. Furthermore, a quantized value obtained by further quantizing the quantized error of the second enhancement encoded data and a quantized error thereof may be separately encoded so that a desired number of pieces of enhancement encoded data is obtained. As such, by using scalable encoding, transmission of encoded data based on the transmission band and allowable transmission time of the data transmission network 2 can be performed.

Note that the encoding unit 11 may encode the higher M bits of non-zero weight data shown in FIG. 8, as base encoded data, and divide the remaining bit string into one or more blocks and obtain one or more pieces of enhancement encoded data. In this case, the encoding unit 11 re-sets a non-zero flag for each of the base encoded data and the enhancement encoded data. A weight that is 0 in higher-bit enhancement encoded data is always 0.

An example of (B) will be described.

When there is a model of an NN before retraining by the training unit 101, the encoding unit 11 may encode a difference between an edge weight in a model of the NN after retraining and a corresponding edge weight in the model before retraining. Note that the retraining includes transfer learning or additional learning. In the data processing system, when a configuration of an NN is updated with a high frequency or a change in a distribution of training data for each retraining is small, a difference between edge weights is small, and thus, the data size of encoded data after retraining is reduced.

The encoding unit 11 includes, in a model information header, a reference model identification number (reference_model_id) for identifying a model before update to be referred to, in addition to a model identification number. In the example of (B), a model before retraining can be identified from the above-described reference model identification number. Furthermore, the encoding unit 11 may set a flag (reference_model_present_flag) indicating whether or not encoded data has a reference source, in the model information header. In this case, the encoding unit 11 first encodes the flag (reference_model_present_flag), and only when the flag indicates encoded data for updating a model, the encoding unit 11 further sets a reference model identification number in the model information header.

For example, in the data processing system shown in FIG. 1, even when the frequency of NN update differs between the clients or the clients perform data processing using different models of an NN, the clients can properly identify which model's encoded data for updating by referring to the reference model identification number. When it is identified from the reference model identification number that encoded data for updating a model is one for a model that is not available on a client side, the client can inform the server 1 of such a fact.

An example of (C) will be described.

When there is a model of an NN before retraining, for example, for the purpose of fine-tuning, the training unit 101 may fix any one or more layers from the highest level (input layer side) of the NN and retrain only the one or more layers. In this case, the encoding unit 11 encodes only information indicating a configuration of a layer updated by the retraining. As a result, in an update to the NN, the data size of encoded data to be transmitted to the decoding side is reduced. Note that the number of encoded layer data units (num_coded_layers) in encoded data is less than or equal to the number of layer data units (num layers) in a model. The decoding side can identify a layer to be updated, by referring to a reference model identification number included in a model information header and a layer identification number included in a layer information header.

Next, data processing performed by the training unit 101, the evaluating unit 102, and the inferring unit 202 will be described.

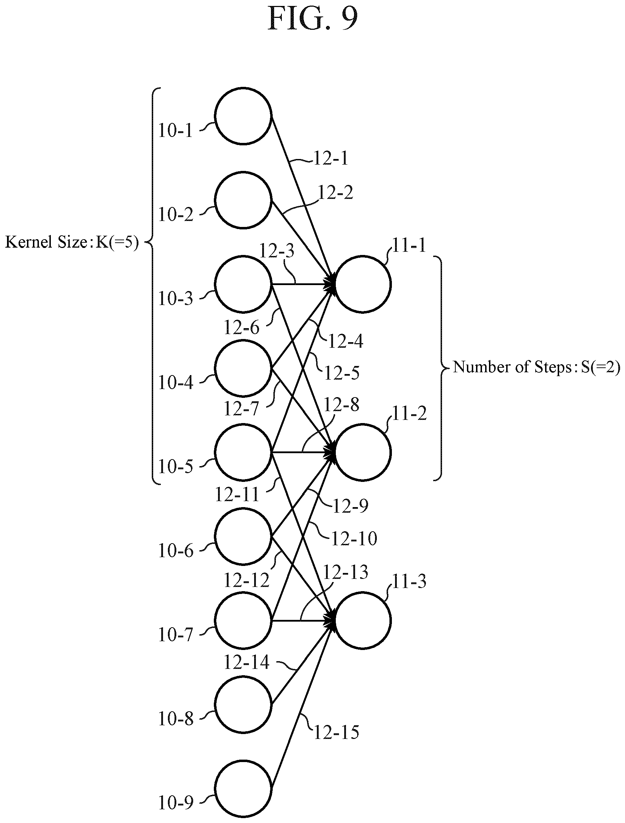

FIG. 9 is a diagram showing an example of a convolution process for one-dimensional data in the first embodiment, and shows convolutional layers that perform a convolution process for one-dimensional data. The one-dimensional data includes, for example, audio data and time-series data. The convolutional layers shown in FIG. 9 include nine nodes 10-1 to 10-9 in a previous layer and three nodes 11-1 to 11-3 in a subsequent layer. Edges 12-1, 12-6, and 12-11 are assigned the same weight, edges 12-2, 12-7, and 12-12 are assigned the same weight, edges 12-3, 12-8, and 12-13 are assigned the same weight, edges 12-4, 12-9, and 12-14 are assigned the same weight, and edges 12-5, 12-10, and 12-15 are assigned the same weight. In addition, the weights of the edges 12-1 to 12-5 may all have different values or a plurality of weights may have the same value.

Of the nine nodes 10-1 to 10-9 in the previous layer, five nodes are connected to one node in the subsequent layer with the above-described weights. The kernel size K is 5 and the kernel is defined by a combination of these weights. For example, as shown in FIG. 9, the node 10-1 is connected to the node 11-1 through the edge 12-1, the node 10-2 is connected to the node 11-1 through the edge 12-2, the node 10-3 is connected to the node 11-1 through the edge 12-3, the node 10-4 is connected to the node 11-1 through the edge 12-4, and the node 10-5 is connected to the node 11-1 through the edge 12-5. The kernel is defined by a combination of the weights of the edges 12-1 to 12-5.

The node 10-3 is connected to the node 11-2 through the edge 12-6, the node 10-4 is connected to the node 11-2 through the edge 12-7, the node 10-5 is connected to the node 11-2 through the edge 12-8, the node 10-6 is connected to the node 11-2 through the edge 12-9, and the node 10-7 is connected to the node 11-2 through the edge 12-10. The kernel is defined by a combination of the weights of the edges 12-6 to 12-10.

The node 10-5 is connected to the node 11-3 through the edge 12-11, the node 10-6 is connected to the node 11-3 through the edge 12-12, the node 10-7 is connected to the node 11-3 through the edge 12-13, the node 10-8 is connected to the node 11-3 through the edge 12-14, and the node 10-9 is connected to the node 11-3 through the edge 12-15. The kernel is defined by a combination of the weights of the edges 12-11 to 12-15.

In a process for input data using a CNN, the training unit 101, the evaluating unit 102, and the inferring unit 202 perform, for each kernel, a convolution operation at intervals of the number of steps (in FIG. 9, S = 2) using a combination of edge weights of a convolutional layer. The combination of edge weights is determined for each kernel by training. Note that in a CNN used for image recognition, an NN is often formed using a convolutional layer including a plurality of kernels.

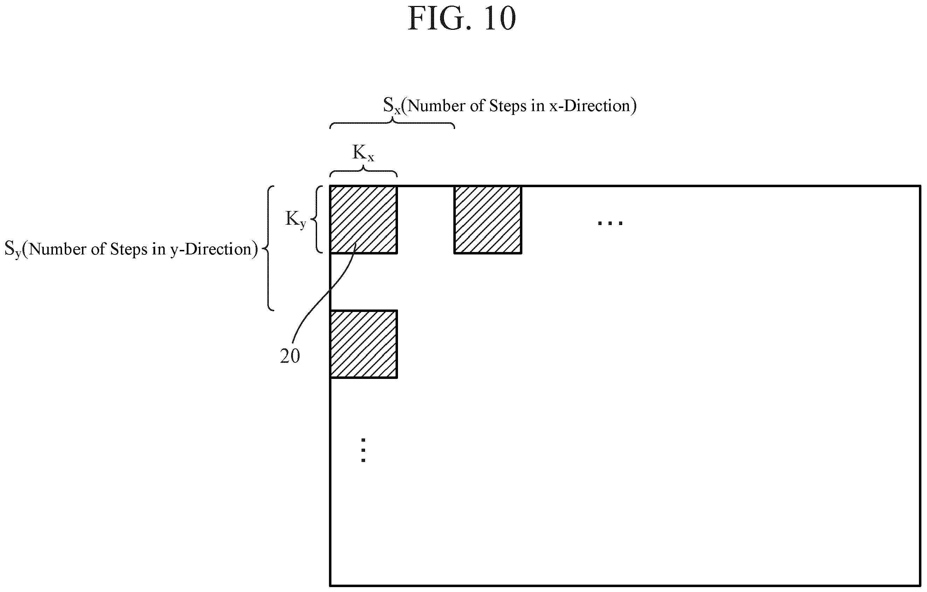

FIG. 10 is a diagram showing an example of a convolution process for two-dimensional data in the first embodiment, and shows a convolution process for two-dimensional data such as image data. In the two-dimensional data shown in FIG. 10, a kernel 20 is a block region whose size in an x-direction is Kₓ and whose size in a y-direction is K_{y}. The kernel size K is K = Kₓ × K_{y}. The training unit 101, the evaluating unit 102, or the inferring unit 202 performs a data convolution operation on the two-dimensional data on a per kernel 20 basis, at intervals of the number of steps in the x-direction Sₓ and intervals of the number of steps in the y-direction S_{y}. Here, the steps Sₓ and S_{y} are integers greater than or equal to 1.

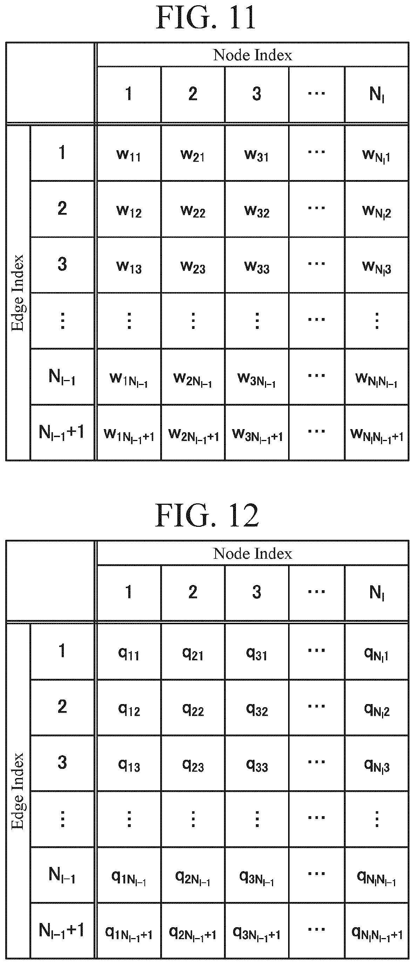

FIG. 11 is a diagram showing a matrix of node-by-node edge weight information in an lth layer (l = 1, 2, ..., L) which is a fully-connected layer of an NN FIG. 12 is a diagram showing a matrix of quantization steps for the node-by-node edge weight information in the lth layer (l = 1, 2, ..., L) which is a fully-connected layer of the NN

In the NN, combinations of weights wij for each layer shown in FIG. 11 are data that forms a network. Hence, in a multi-layer NN such as a deep neural network, the amount of data is generally several hundred Mbytes or more and a large memory size is required. i is the node index and i = 1, 2, ..., N₁. j is the edge index and j = 1, 2, ..., Nₗ₋₁+1 (including an offset).

Hence, in order to reduce the amount of data of edge weight information, the data processing device according to the first embodiment quantizes the weight information. For example, as shown in FIG. 12, the quantization step qᵢⱼ is set for each edge weight wᵢⱼ. The quantization step may be common to a plurality of node indices or a plurality of edge indices, or common to a plurality of node indices and edge indices. As a result, quantization information to be encoded is reduced.

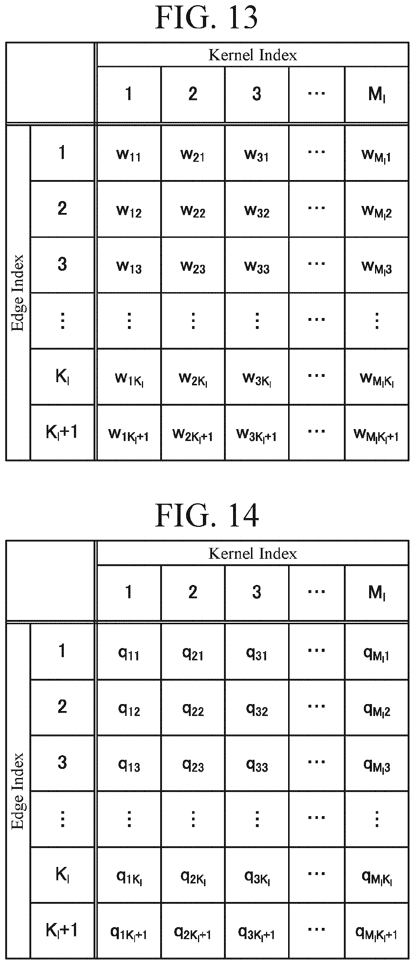

FIG. 13 is a diagram showing a matrix of edge weight information in a convolutional layer. FIG. 14 is a diagram showing a matrix of quantization steps for the edge weight information in the convolutional layer. In the convolutional layer, an edge weight for one kernel is common for all nodes, and by reducing the number of edges connected per node, i.e., the kernel size K, the kernel can be formed into a small region. FIG. 13 is data in which the edge weight w_{i'j'} is set for each kernel, and FIG. 14 is data in which the quantization step q_{i'j'} is set for each kernel. Note that i' is the kernel index and i' = 1, 2, ..., Mₗ (l = 1, 2, ..., L). j' is the edge index and j' = 1, 2, ..., Kₗ+1 (including an offset).

The quantization step may be common to a plurality of kernel indices, a plurality of edge indices, or a plurality of kernel indices and edge indices. As a result, quantization information to be encoded is reduced. For example, all quantization steps in a layer may be a common quantization step, and thus one quantization step is used for one layer, or all quantization steps in a model may be a common quantization step, and thus one quantization step may be used for one model.

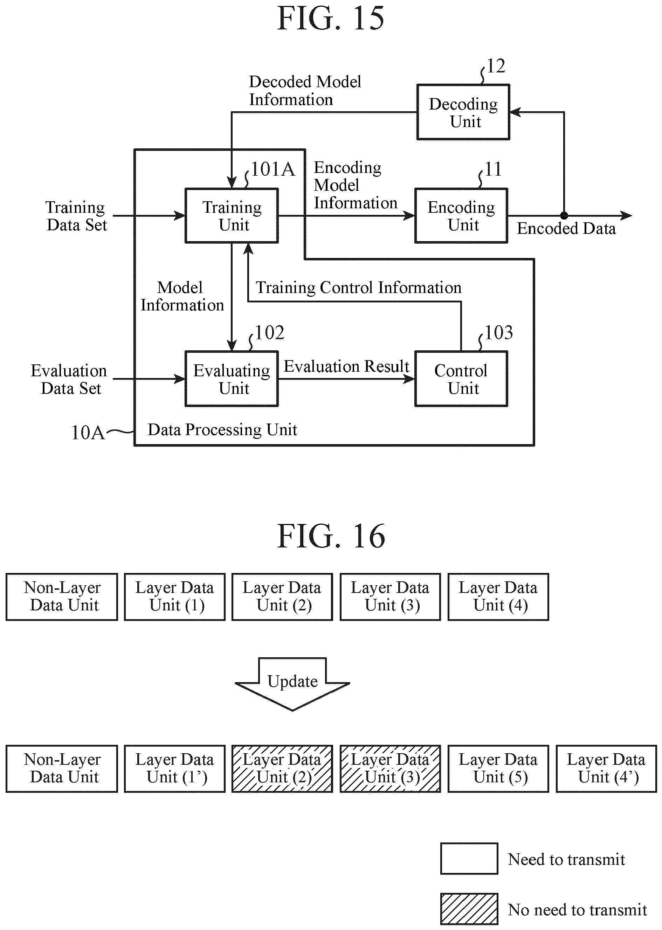

FIG. 15 is a block diagram showing a configuration of a variant of the data processing device (encoder) according to the first embodiment. The data processing device shown in FIG. 15 is a first data processing device that trains an NN using a training data set and an evaluation data set, and generates encoded data of model information of the NN, and is, for example, the server 1 shown in FIG. 1. The data processing device shown in FIG. 15 includes a data processing unit 10A, the encoding unit 11, and a decoding unit 12.

The data processing unit 10A is a data processing unit that creates and trains an NN, and includes a training unit 101A, the evaluating unit 102, and the control unit 103. The encoding unit 11 encodes model information generated by the training unit 101A, thereby generating encoded data including header information and layer-by-layer encoded data. The decoding unit 12 decodes model information from the encoded data generated by the encoding unit 11. In addition, the decoding unit 12 outputs the decoded model information to the training unit 101A.

As with the training unit 101, the training unit 101A trains an NN using a training data set, and generates model information indicating a configuration of the trained NN In addition, the training unit 101A creates an NN using decoded model information, and retrains parameters of the created NN using a training data set.

Upon the above-described retraining, by performing the retraining with some edge weights being fixed, an increase in accuracy can be achieved while the data size of encoded data is kept small. For example, by performing retraining with a weight whose non-zero flag is 0 being fixed at 0, optimization of weights is possible while the data size of encoded data is prevented from being greater than or equal to the data size of encoded data for edge weights before the retraining.

The data processing device includes the decoding unit 12, and the data processing unit 10A trains an NN using information decoded by the decoding unit 12. Thus, for example, even when the encoding unit 11 performs irreversible encoding by which encoding distortion occurs, the data processing device can create and train an NN on the basis of actual decoding results of encoded data, and thus can train the NN so that minimizes the influence of encoding errors, under circumstances where a limitation on the data size of encoded data is imposed.

In a data processing system that has the same configuration as that in FIG. 1, and includes the data processing device shown in FIG. 3 as the server 1 and includes the data processing devices shown in FIG. 4 as the clients 3-1, 3-2, ..., 3-N, data outputted from an intermediate layer of an NN can be used as one or more features for data processing for image data and audio data, e.g., image retrieval or matching described in the following reference document 1.

(Reference document 1) ISO/IEC JTC1/SC29/WG11/m39219, "Improved retrieval and matching with CNN feature for CDVA", Chengdu, China, Oct. 2016.

For example, when output data from an intermediate layer of an NN is used as image features for image processing such as image retrieval, matching, or object tracking, substitution or addition of image features is performed on a histogram of oriented gradients (HOG), scale invariant feature transform (SIFT), or speeded up robust features (SURF) which is image features used in the above-described conventional image processing. As a result, by the same processing procedure as image processing that uses conventional image features, the image processing can be implemented. In the data processing system according to the first embodiment, the encoding unit 11 encodes model information indicating a configuration of a portion of an NN up to an intermediate layer that outputs image features.

Furthermore, the data processing device that functions as the server 1 performs data processing such as image retrieval, using features for the above-described data processing. A data processing device that functions as a client creates an NN up to an intermediate layer from encoded data, and performs data processing such as image retrieval, using, as features, data outputted from the intermediate layer of the created NN

In the data processing system, the encoding unit 11 encodes model information indicating a configuration of an NN up to an intermediate layer, by which the compression ratio of parameter data by quantization increases, thereby enabling a reduction in the amount of data of weight information before encoding. A client creates an NN using model information decoded by the decoding unit 201 and performs data processing that uses, as features, data outputted from an intermediate layer of the created NN

In addition, the data processing system according to the first embodiment has the same configuration as that in FIG. 1, and can include the data processing device shown in FIG. 3 or 15 as the server 1 and include the data processing devices shown in FIG. 4 as the clients 3-1, 3-2, ..., 3-N. In the data processing system having this configuration, a new layer flag (new layer flag) is set in encoded data. When the new layer flag is 0 (false), a layer corresponding to the new layer flag is a layer to be updated with reference to a reference layer. When the new layer flag is 1 (true), a layer corresponding to the new layer flag is a layer to be newly added.

When the new layer flag is 0 (false), a flag (channel_wise_update_flag) for identifying whether or not edge weights are updated on a channel-by-channel basis is set for a layer corresponding to the new layer flag. When the flag is 0 (false), edge weights for all channels are encoded. When the flag is 1 (true), a channel-by-channel weight update flag (channel update _flag) is set. This update flag is a flag indicating, for each channel, whether or not an update is performed from a reference layer. When the update flag is 1 (true), a weight for the corresponding channel is encoded, and when the update flag is 0 (false), the same weight as that of the reference layer is set.

Furthermore, as a layer information header, information (num_channels) indicating the number of channels in a layer and information (weights_per_channels) indicating the number of channel-by-channel edge weights are set. The weights_per_channels for a given layer 1 indicates kernel size Kₗ+1 or the number of edges Nₗ₋₁+1 from a layer 1-1 which is an immediately previous layer.

By including the aforementioned new layer flag in encoded data, the number of channels and the number of channel-by-channel weights can be identified only from the encoded data of a layer data unit. Thus, in a decoding process for the layer data unit, the channel-by-channel weight update flag can be decoded.

In addition, a case in which a flag for identifying whether or not weights are updated on a channel-by-channel basis is set to 1 (true) is limited to when the number of channels is identical to that of a reference layer. The reason therefor is that when the number of channels differs from that of the reference layer, a correspondence relationship between the channels is unknown between the reference layer and a layer corresponding to the above-described flag.

FIG. 16 is a diagram showing an overview of an update to encoded data in the first embodiment. In FIG. 16, data shown on top includes a non-layer data unit and layer data units (1) to (4), and as in FIG. 7, encoding is performed in turn from the layer data unit (4). In the non-layer data unit, as model header information, a model identification number (model_id) = 0, the number of layer data units in a model (num layers) = 4, layer structure information (model_structure_information), and layer identification information (layer_id_information) are set, and a flag (reference_model_present_flag) indicating whether or not encoded data has a reference source is set to 0 (false).

In the layer data unit (1), the layer identification number (layer id) is set to 0, information (num_channels) indicating the number of channels (filters or kernels) in a layer is set to 32, and information (weights_per_channels) indicating the number of channel-by-channel (filter-by-filter or kernel-by-kernel) weights (including bias values) is set to 76. In addition, in the layer data unit (2), the layer identification number (layer id) is set to 1, information (num_channels) indicating the number of channels in a layer is set to 64, and information (weights_per_channels) indicating the number of channel-by-channel weights is set to 289.

In the layer data unit (3), the layer identification number (layer id) is set to 2, information (num_channels) indicating the number of channels in a layer is set to 128, and information (weights_per_channels) indicating the number of channel-by-channel weights is set to 577. In addition, in the layer data unit (4), the layer identification number (layer id) is set to 3, information (num_channels) indicating the number of channels in a layer is set to 100, and information (weights_per_channels) indicating the number of channel-by-channel weights is set to 32769.

In FIG. 16, data shown on bottom is data updated from the data shown on top, using layer structure information, a layer update flag, and a new layer flag, and includes a non-layer data unit and layer data units (1'), (2), (3), (5), and (4'). The non-layer data unit and the layer data units (1'), (5), and (4') need to be transmitted (Need to transmit) to a client to which the data shown on top has been transmitted, but the layer data units (2) and (3) are not updated and thus do not need to be transmitted (No need to transmit) to the client.

In the non-layer data unit shown on bottom of FIG. 16, as model header information, a model identification number (model_id) = 10, the number of layer data units in a model (num layers) = 5, layer structure information (model_structure_information), and layer identification information (layer_id_information) are set, and a flag (reference_model_present_flag) indicating whether or not encoded data has a reference source is set to 1 (true), a reference model identification number (reference_mode_id) is set to 0, and the number of encoded layer data units (num_coded_layers) is set to 3.

In the layer data unit (1'), the layer identification number (layer id) is 0, the new layer flag (new layer flag) is set to 0, information (num_channels) indicating the number of channels in a layer is set to 32, and information (weights_per__channels) indicating the number of channel-by-channel weights is set to 76. In addition, a flag (channel wise update flag) for identifying whether or not weights are updated on a channel-by-channel basis is set to 1 (true), and thus, a channel-by-channel weight update flag (channel_update_flag) is set.

The layer data unit (2) whose layer identification number (layer id) is 1 and the layer data unit (3) whose layer identification number (layer id) is 2 are not update targets, and thus are not included in encoded data. Hence, in the above-described model header information, the number of layer data units in a model (num layers) = 5 and the number of encoded layer data units (num_coded_layers) = 3 are set.

In the layer data unit (5), the layer identification number (layer id) is 4, and the new layer flag (new layer flag) is set to 1 (true). In addition, information (num_channels) indicating the number of channels in a layer is set to 256, and information (weights_per_channels) indicating the number of channel-by-channel weights is set to 1153.

In the layer data unit (4'), the layer identification number (layer id) is 3, the new layer flag (new layer flag) is set to 0, information (num_channels) indicating the number of channels in a layer is set to 100, and information (weights_per_channels) indicating the number of channel-by-channel weights is set to 16385. In addition, a flag (channel_wise_update_flag) for identifying whether or not weights are updated on a channel-by-channel basis is set to 0 (false), and there is no update to channel-by-channel weights.

In the data shown on bottom, the layer data units (1) and (4) in the data shown on top are updated to the layer data units (1') and (4'), and furthermore, the layer data unit (5) whose layer identification number is 4 is added.

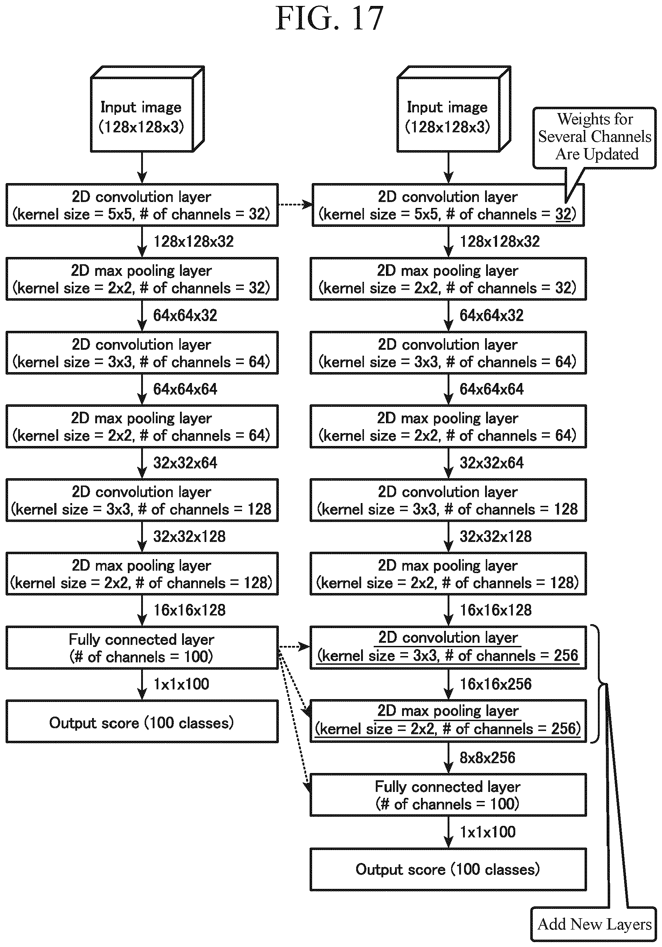

FIG. 17 is a diagram showing configurations of network models corresponding to the update to the encoded data shown in FIG. 16. In FIG. 17, a network model shown on the left side is a network model implemented by decoding the data shown on top of FIG. 16. In addition, a network model shown on the right side is a network model implemented by decoding the data shown on bottom of FIG. 16.

In the layer data unit (1'), since the flag (channel wise update flag) for identifying whether or not weights are updated on a channel-by-channel basis is 1, weights for several channels are updated from the layer data unit (1). In addition, by adding the layer data unit (5) and updating the layer data unit (4) to the layer data unit (4'), in the network model shown on the right side, a 2D convolution layer and a 2D max pooling layer are added before a fully connected layer.

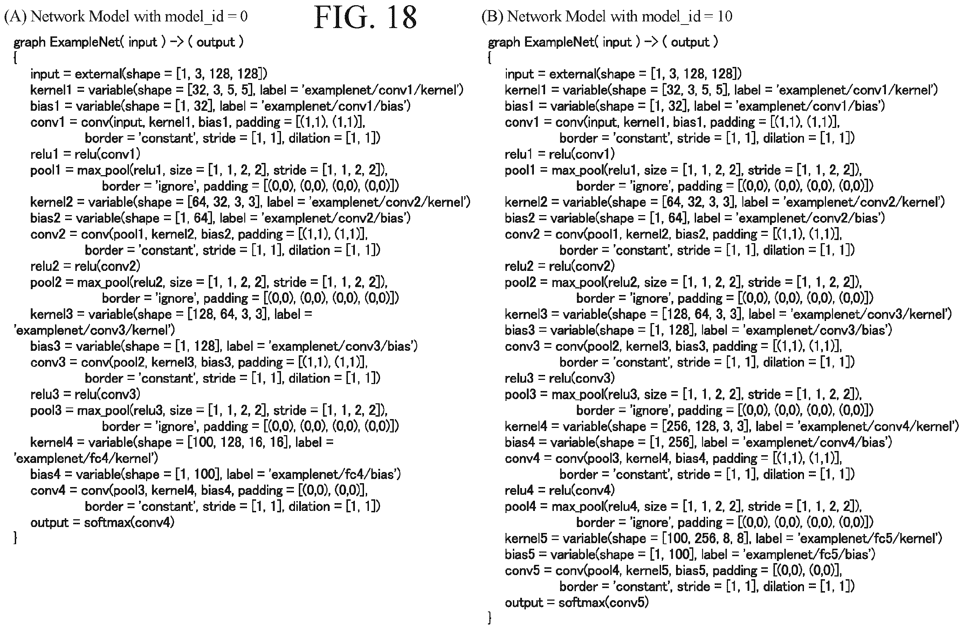

FIG. 18 is a diagram showing examples of layer structure information included in a model information header. As for all layer structure information (model_structure_information) included in a model information header, text information such as that shown in FIG. 18 may be set. The text information shown in FIG. 18 is text information indicating a layer structure of a model based on a standard described in reference document 2, called neural network exchange format (NNEF). (Reference document 2) "Neural Network Exchange Format", The Khronos NNEF Working Group, Version 1.0, Revision 3, 2018-06-13.

In FIG. 18, (A) a network model with model_id = 0 is a network model corresponding to the data shown on top of FIG. 16 (the network model shown on the left side of FIG. 17). (B) a network model with model_id = 10 is a network model corresponding to the data shown on bottom of FIG. 16 (the network model shown on the right side of FIG. 17).

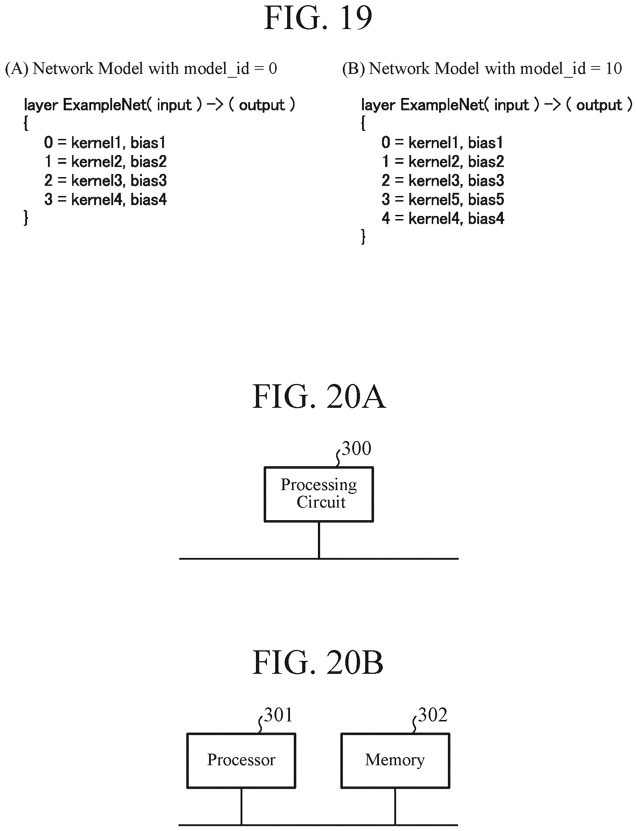

FIG. 19 is a diagram showing examples of layer identification information (layer_id_information) corresponding to layer structure information included in a model information header, and shows layer identification information in which layer identification numbers corresponding to the layer structure information of FIG. 18 are set. In FIG. 19, (A) a network model with model_id = 0 has layer identification information corresponding to the network model shown on the left side of FIG. 17. (B) a network model with model_id = 10 has layer identification information corresponding to the network model shown on the right side of FIG. 17. A weight and a bias value of each layer are assigned to the corresponding layer identification number, and the values thereof correspond to the data shown in FIG. 16.

In a configuration of encoded data, pieces of file data of a file in which model_structure_information which is all layer structure information and layer_id_information which is information indicating layer identification numbers corresponding to the all layer structure information are described, etc., are included in such a manner that in a model information header, each of the pieces of file data is inserted after information indicating the number of bytes of a corresponding one of the pieces of file data. Alternatively, it is also possible to adopt another configuration in which a uniform resource locator (URL) indicating where the pieces of file data are located is included in the model information header. Furthermore, in order to be able to select any of these configurations, a flag that identifies which configuration is used may be set before the pieces of file data or the URL in the model information header. The above-described identification flag may be common to model_structure_information and layer_id_information or may be individually set for model_structure_information and layer_id_information. In the former, the amount of information of the model information header can be reduced, and in the latter, the identification flag can be independently set depending on a precondition upon use.

Furthermore, the model information header includes information indicating a format of the above-described text information. For example, the information indicates that NNEF has the index 0 and other formats each have the index 1 or larger. As a result, in which format the text information is described can be identified, and decoding can be performed properly.

Note that layer structure information and information indicating layer identification numbers corresponding to the layer structure information which are indicated by respective pieces of text information such as those shown in FIGS. 18 and 19 can be applied to all systems shown in the first embodiment. Furthermore, by model_structure_information and layer_id_information, which layer's data in a model each layer data unit corresponds to can be identified only from the encoded data. Thus, when a model is updated (when reference_model_present_flag is true), it is also possible to set, as a reference model, a model that is not created from encoded data shown in the present embodiment. Namely, by including, in encoded data shown in the present embodiment, model_structure_information and layer_id_information as a part of a model information header, any model can be set as a reference model. Note that in this case there is a need to separately define associations between reference model identification numbers (reference_model_id) and respective reference models.

Next, a hardware configuration that implements functions of a data processing device according to the first embodiment will be described. The functions of the data processing unit 10 and the encoding unit 11 in the data processing device according to the first embodiment are implemented by a processing circuit. Namely, the data processing device according to the first embodiment includes a processing circuit for performing the processes from step ST1 to step ST6 of FIG. 5. The processing circuit may be dedicated hardware, but may be a central processing unit (CPU) that executes programs stored in a memory.

FIG. 20A is a block diagram showing a hardware configuration that implements the functions of the data processing device according to the first embodiment. In FIG. 20A, a processing circuit 300 is a dedicated circuit that functions as the data processing device shown in FIG. 3. FIG. 20B is a block diagram showing a hardware configuration that executes software that implements the functions of the data processing device according to the first embodiment. In FIG. 20B, a processor 301 and a memory 302 are connected to each other by a signal bus.

When the above-described processing circuit is the dedicated hardware shown in FIG. 20A, the processing circuit 300 corresponds, for example, to a single circuit, a combined circuit, a programmed processor, a parallel programmed processor, an application specific integrated circuit (ASIC), a field-programmable gate array (FPGA), or a combination thereof. Note that the functions of the data processing unit 10 and the encoding unit 11 may be implemented by different processing circuits, or the functions may be collectively implemented by a single processing circuit.

When the above-described processing circuit is the processor shown in FIG. 20B, the functions of the data processing unit 10 and the encoding unit 11 are implemented by software, firmware, or a combination of software and firmware. The software or firmware is described as programs and stored in the memory 302. The processor 301 implements the functions of the data processing unit 10 and the encoding unit 11 by reading and executing the programs stored in the memory 302. Namely, the data processing device according to the first embodiment includes the memory 302 for storing programs that when executed by the processor 301, cause the processes from step ST1 to step ST6 shown in FIG. 5 to be consequently performed. The programs cause a computer to perform procedures or methods performed in the data processing unit 10 and the encoding unit 11. The memory 302 may be a computer readable storage medium having stored therein programs for causing a computer to function as the data processing unit 10 and the encoding unit 11.

The memory 302 corresponds, for example, to a nonvolatile or volatile semiconductor memory such as a random access memory (RAM), a read only memory (ROM), a flash memory, an erasable programmable read only memory (EPROM), or an electrically-EPROM (EEPROM), a magnetic disk, a flexible disk, an optical disc, a compact disc, a MiniDisc, or a DVD.

Note that some of the functions of the data processing unit 10 and the encoding unit 11 may be implemented by dedicated hardware, and some of the functions may be implemented by software or firmware. For example, the functions of the data processing unit 10 may be implemented by a processing circuit which is dedicated hardware, and the function of the encoding unit 11 may be implemented by the processor 301 reading and executing a program stored in the memory 302. As such, the processing circuit can implement each of the above-described functions by hardware, software, firmware, or a combination thereof.

Note that although the data processing device shown in FIG. 3 is described, the same also applies to the data processing device shown in FIG. 4. For example, the data processing device shown in FIG. 4 includes a processing circuit for performing the processes at step ST11 to ST13 of FIG. 6. The processing circuit may be dedicated hardware, but may be a CPU that executes programs stored in a memory.

When the above-described processing circuit is the dedicated hardware shown in FIG. 20A, the processing circuit 300 corresponds, for example, to a single circuit, a combined circuit, a programmed processor, a parallel programmed processor, an ASIC, an FPGA, or a combination thereof. Note that the functions of the decoding unit 201 and the inferring unit 202 may be implemented by different processing circuits, or the functions may be collectively implemented by a single processing circuit.

When the above-described processing circuit is the processor shown in FIG. 20B, the functions of the decoding unit 201 and the inferring unit 202 are implemented by software, firmware, or a combination of software and firmware. The software or firmware is described as programs and stored in the memory 302. The processor 301 implements the functions of the decoding unit 201 and the inferring unit 202 by reading and executing the programs stored in the memory 302. Namely, the data processing device shown in FIG. 4 includes the memory 302 for storing programs that when executed by the processor 301, cause the processes at step ST11 to ST13 shown in FIG. 6 to be consequently performed. The programs cause a computer to perform procedures or methods performed in the decoding unit 201 and the inferring unit 202. The memory 302 may be a computer readable storage medium having stored therein programs for causing a computer to function as the decoding unit 201 and the inferring unit 202.

Note that one of the functions of the decoding unit 201 and the inferring unit 202 may be implemented by dedicated hardware, and the other one of the functions may be implemented by software or firmware. For example, the function of the decoding unit 201 may be implemented by a processing circuit which is dedicated hardware, and the function of the inferring unit 202 may be implemented by the processor 301 reading and executing a program stored in the memory 302.

As described above, in the data processing device according to the first embodiment, when the encoding unit 11 encodes layer structure information and encodes a layer update flag, and the layer update flag indicates an update to a layer structure, a new layer flag is encoded. Of pieces of data representing a structure of an NN, only information about an updated layer is encoded and transmitted, and thus, a data size of the pieces of data representing a structure of an NN can be reduced.

In addition, the encoding unit 11 encodes information indicating a configuration of an NN, thereby generating encoded data including header information and layer-by-layer encoded data. Since only information about a layer required for the decoding side can be encoded, the processing load for encoding information about a configuration of an NN is reduced, and a reduction in a size of data to be transmitted to the decoding side can be achieved.

In the data processing device according to the first embodiment, the encoding unit 11 encodes weight information of edges belonging to a layer of an NN on a bit-plane-by-bit-plane basis from higher bits. Thus, the data size of encoded data to be transmitted to the decoding side can be reduced.

In the data processing device according to the first embodiment, the encoding unit 11 encodes information about one or more layers specified by header information. Thus, only information about a layer required for the decoding side is encoded, thereby enabling a reduction in the data size of encoded data to be transmitted to the decoding side.

In the data processing device according to the first embodiment, the encoding unit 11 encodes a difference between a weight value of an edge belonging to a layer specified by header information and a specific value. Thus, the data size of encoded data to be transmitted to the decoding side can be reduced.

In the data processing device according to the first embodiment, the encoding unit 11 encodes edge weight information as base encoded data and enhancement encoded data separately. Thus, transmission of encoded data based on the transmission band and allowable transmission time of the data transmission network 2 can be implemented.

Note that the present invention is not limited to the above-described embodiments, and a free combination of the embodiments, modification to any component in each of the embodiments, or omission of any component in each of the embodiments is possible within the scope of the present invention.

### INDUSTRIAL APPLICABILITY

A data processing device according to the present invention can be used for, for example, image recognition techniques.

### REFERENCE SIGNS LIST

1: server, 2: data transmission network, 3-1 to 3-N: client, 10, 10A: data processing unit, 10-1 to 10-9, 11-1 to 11-3: node, 11: encoding unit, 12: decoding unit, 12-1 to 12-15: edge, 20: kernel, 101, 101A: training unit, 102: evaluating unit, 103: control unit, 201: decoding unit, 202: inferring unit, 300: processing circuit, 301: processor, 302: memory

## Claims

1. A data processing device comprising:
a data processing unit for training a neural network; and
an encoding unit for generating encoded data in which model header information for identifying a model of the neural network, layer header information for identifying one or more layers of the neural network, and layer-by-layer edge weight information are encoded, wherein
the encoding unit encodes layer structure information indicating a layer structure of the neural network, and a new layer flag indicating whether each of the layers to be encoded is a layer to be updated from a corresponding layer of a reference model, or a new layer.

2. The data processing device according to claim 1, wherein the encoding unit encodes weight information of edges belonging to each of the one or more layers, on a bit-plane-by-bit-plane basis from higher bits.

3. The data processing device according to claim 1 or 2, wherein the encoding unit encodes weight information of edges belonging to each of the one or more layers identified by the layer header information.

4. The data processing device according to claim 1 or 2, wherein the encoding unit encodes a difference between an edge weight value and a specific value.

5. The data processing device according to claim 1 or 2, wherein the encoding unit encodes the edge weight information as base encoded data and enhancement encoded data separately.

6. The data processing device according to claim 1 or 2, comprising a decoding unit for decoding the encoded data generated by the encoding unit, wherein
the data processing unit trains the neural network using information decoded by the decoding unit.

7. A data processing system comprising:
a first data processing device including:
a first data processing unit for training a neural network; and
an encoding unit for generating encoded data in which model header information for identifying a model of the neural network, layer header information for identifying one or more layers of the neural network, and layer-by-layer edge weight information are encoded; and
a second data processing device including:
a decoding unit for decoding the encoded data generated by the encoding unit; and
a second data processing unit for creating the neural network using information decoded by the decoding unit, and performing data processing using the neural network, wherein
the encoding unit encodes layer structure information indicating a layer structure of the neural network, and a new layer flag indicating whether each of the layers to be encoded is a layer to be updated from a corresponding layer of a reference model, or a new layer.

8. The data processing system according to claim 7, wherein
the encoding unit encodes information about a portion of the neural network up to an intermediate layer, and
the second data processing device performs data processing using, as a feature, data outputted from the intermediate layer of the neural network.

9. A data processing method comprising the steps of:
training a neural network by a data processing unit; and
generating, by an encoding unit, encoded data in which model header information for identifying a model of the neural network, layer header information for identifying one or more layers of the neural network, and layer-by-layer edge weight information are encoded, wherein
the encoding unit encodes layer structure information indicating a layer structure of the neural network, and a new layer flag indicating whether each of the layers to be encoded is a layer to be updated from a corresponding layer of a reference model, or a new layer.
